# EUROPEAN PATENT APPLICATION

(11) **EP 0 545 458 A1**
(43) Date of publication of application: **09.06.1993**
(21) Application number: 92203537.3
(22) Date of filing: 18.11.1992
(51) Int. Cl.: G03F 7/115, B05B 5/04

(54) **Method and apparatus for the matting of light-sensitive printing plates**

(30) Priority: 28.11.1991 IT MI913186
(71) Applicant: LASTRA S.P.A., I-25025 Manerbio (IT)
(72) Inventor: Bolli, Angelo, I-25025 Manerbio (Brescia) (IT); Paulesu, Angelo, I-20138 Milano (IT); Ziletti, Giuseppe, I-25025 Manerbio (Brescia) (IT); Canestri, Giuseppe, I-47037 Rimini (Forli) (IT)
(74) Representative: Marchi, Massimo

(57) **Abstract**

A method and an apparatus have been developed for the matting of light-sensitive printing plates (1); the method is based on the spraying of a beam of finely-divided droplets of a low-viscosity composition comprising one or more compounds suitable for matting and a solvent, so that, by evaporation of a large part of said solvent, said droplets are very viscous when they reach the light-sensitive layer, they adhere to it, and dry quickly, forming minuscule protrusions; the apparatus comprises spraying means (5) capable of directing on said printing plate (1) said beam of finely-divided droplets.

## Description

The present invention relates to a method and apparatus for the matting of tight-sensitive printing plates.

It is known that, in order to obtain a contact between the upper light-sensitive layer of a light-sensitive plate and the original to be reproduced, plate and original are placed one on top of the other between a sheet of elastomeric material and a plate of glass which presses the original on the light-sensitive layer; a vacuum is then produced between the sheet of elastomeric material and the plate of glass. This is called the "vacuum-contact" method.

When the surface of the light-sensitive layer is too smooth, the adhesion between the light-sensitive plate and the original in the peripheral area makes it very difficult to produce a vacuum in the central area, where there may be formed areas of separation which severely jeopardize the quality of the image.

In order to make easy the uniform evacuation of air during the vacuum-contact process, the surface of the light-sensitive layer has small protrusions which prevents the original film from adhering sealingly to the surface of the light-sensitive layer. The treatment which produces such small protrusions is called matting.

The English patent No. 1,495,361 teaches the accomplishment of matting by applying over the light-sensitive layer a coating of a light transparent resin, soluble in the development solution, containing solid particles having an average diameter of 2-40 microns. This method, however, has the disadvantage that the solid particles removed by the development bath accumulate in the automatic development apparatus, and make it difficult their maintenance.

The English patent No. 1,512,080 intends to overcome this drawback by accomplishing matting with a layer of viscous resin applied with a roller having a rough surface. The viscosity of the resin used should be such that the irregularities created by the roller remain unaltered until the layer of matting has dried.

It is self-evident that it is very difficult to carry out this process on an industrial scale due to the very high viscosity of resin.

The English patent No. 1,542,131 relates to a similar solution, except that the matting layer may also comprise solid particles, as in the process disclosed by the English patent No. 1,495,361.

Finally the US patent No. 4,560,636 and the English application No. 2,046,461 teach to incorporate inorganic or organic particles in the light-sensitive layer instead of in a layer applied over the light-sensitive layer. Industrial production is thus simplified, but even in this case the solid particles insoluble in the development bath accumulate in the automatic development apparatus, and make it difficult their maintenance.

An object of the present invention is to provide a method for applying, in a simple and effective manner, over the light-sensitive layer of a light-sensitive plate, a matting layer made of compounds which are easily soluble in the development bath.

Another object of the invention is to provide an apparatus which allows said method to be carried out in a simple and quick manner.

According to these objects, the method of this invention for applying a matting layer over the light-sensitive layer of a printing plate comprising a support and a light-sensitive layer, is characterized in that (i) over said light-sensitive layer there is sprayed a beam of finely-divided droplets of a low-viscosity composition comprising at least a solvent and at least a compound suitable for matting and easily soluble in a development bath, and (ii) the spraying step is performed under such conditions that a large part of said solvent evaporates before said droplets reach said light-sensitive layer, so that said droplets are very viscous when they reach said light-sensitive layer, adhere to it, and dry quickly, thus forming minuscule protrusions.

Preferably, said printing plate is made to slide while performing said spraying step. Even more preferably a pre-set electrical charge is supplied to said beam of finely-divided droplets.

Further preferred features of the method of this invention are that
- said beam of finely-divided droplets is formed by means of an atomization bowl feeded at a pre-selected rate with said low-viscosity composition;
- said atomization bowl rotates at a pre-selected rate and at a pre-selected distance from said printing plate, being inclined at a pre-selected angle to said printing plate, in order that a large part of said solvent evaporates before said droplets reach said light-sensitive layer, so that said droplets are highly viscous when they reach said light-sensitive layer, adhere to it, and dry quickly, thus forming minuscule protrusions, and/or
- around said beam of finely-divided droplets, an air cone is formed capable of containing said beam externally, and/or
- said printing plate is kept at a temperature of from 40°C to 60°C.

In view of said objects the apparatus according to the invention for applying a matting layer over the light-sensitive layer of a printing plate comprising a support and a light-sensitive layer, is characterized in that it comprises
- spraying means capable of directing on said light-sensitive layer a beam of finely-divided droplets of a low-viscosity composition comprising at least a solvent and at least a compound suitable for matting and easily soluble in a development bath,
- said spraying means being operated under such conditions that a large part of said solvent evaporates before said droplets reach said light-sensitive layer, so that said droplets are very viscous when they reach said light-sensitive layer, adhere to it, and dry quickly, thus forming minuscule protrusions.

According to a preferred embodiment said apparatus is also characterized in that it comprises guide means for making said printing plate to slide while said spraying step is performed, and also means capable of delivering a pre-selected electrical charge to said beam of finely-divided droplets.

Preferably said spraying means comprise in turn
- an atomization bowl feeded at a pre-selected rate with said low-viscosity composition, and
- said atomization bowl rotates at a pre-selected rate and at a pre-selected distance from said printing plate, being inclined at a pre-selected angle to said printing plate.

Advantageously, said apparatus comprises means suitable to form, around said beam of finely-divided droplets, an air cone capable of containing said beam externally, and said printing plate has a temperature of from 40°C to 60°C.

In accordance with the method and the apparatus of this invention, said composition comprising at least a solvent and at least a compound suitable for matting, has a low viscosity before it is sprayed, while, due to the evaporation of the solvent, it becomes highly viscous when it reaches the surface of said printing plate, so that it adheres to plate itself and dries quickly, thus forming minuscule protrusions.

Examples of substances suitable for matting are polyacrylic acid, polyacrylamide, polyvinylpyrrolidone, soluble amides, soluble co-polymers of polyvinylacetate and crotonic acid, polyvinyl acid, soluble carboxy-methyl cellulose, hydroxy-methyl cellulose soluble polymers of maleic anhydride and vinylether, and the like.

Examples of solvents suitable for the matting composition of this invention are water, lower aliphatic alcohols and aqueous ammmonia (ammonium hydroxide).

Features and advantages of the invention shall now be illustrated with reference to a preferred embodiment, represented as a non-limiting example in the enclosed drawings, wherein:
Fig. 1 shows an apparatus for matting according to this invention;

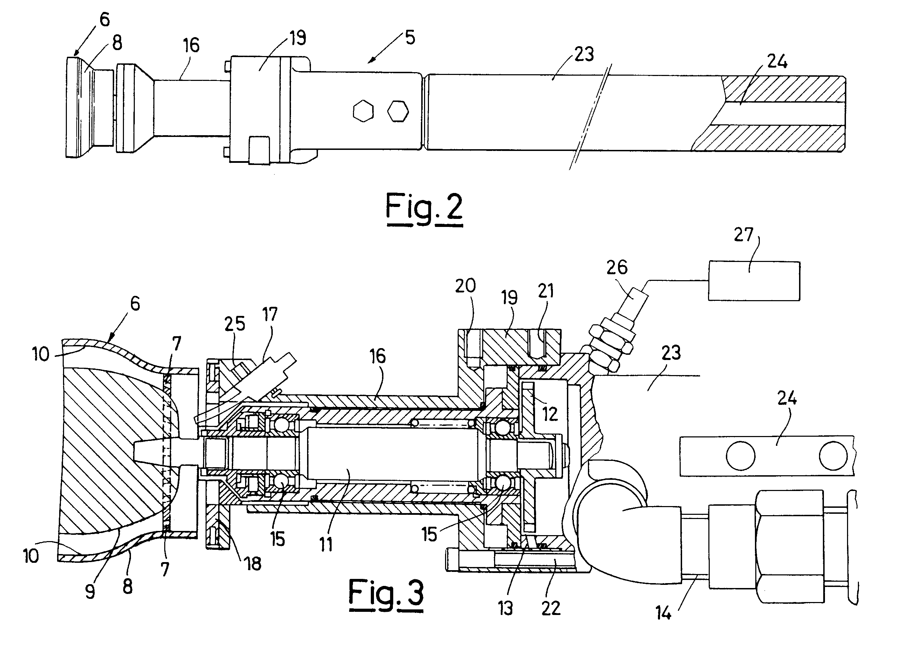

in Fig. 2 there are represented on an enlarged scale the spraying means of the apparatus of Fig. 1;
in Fig. 3 there are represented on an enlarged scale, partially in a longitudinal cross-sectional view, the spraying means of the apparatus of Fig. 2.

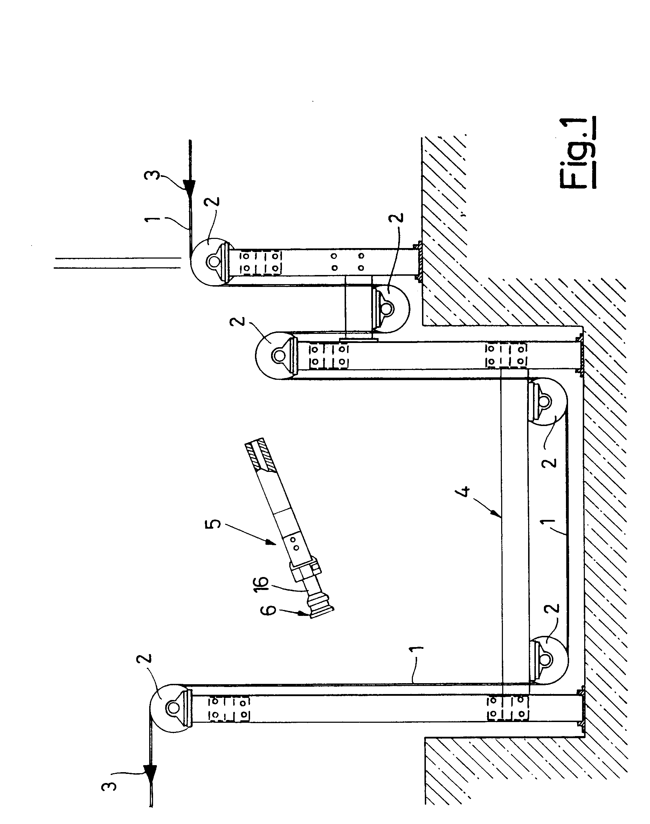

Fig. 1 shows a strip of a light-sensitive printing plate 1 comprising a support made of aluminium or an alloy thereof, and a light-sensitive layer made of a suitable known composition. The strip, that is kept at a temperature of about 50°C, moves at a pre-selected speed, preferably at, 8-10 m/min, in the direction of the arrows 3; there are indicated with 2 the strip's guide rollers, assembled idle in a supporting structure, indicated as a whole with 4, that is placed in a forced-suction chamber, which is not shown.

A spraying unit 5 is capable of directing on the printing plate 1 a beam of finely-divided droplets of a low-viscosity composition, having a preferred viscosity of from 2 to 10 centipoises.

As shown in Fig.s 2 and 3, the unit 5 comprises an atomization bowl, indicated as a whole with 6, provided with an external shaped wall 8, with internal shaped walls 9 and 10 and with a crown of holes 7 having a pre-selected size; the bowl 6 is made to rotate by a shaft 11 integral with a turbine motor 12, operated by a flow of compressed air at a pre-selected pressure, supplied by jets 13; there is indicated with 14 the discharge line of the air operating the turbine motor 10.

The shaft 11 is rotatably supported, by means of ball bearings 15, in a tubular casing 16, in which there is a nozzle 17 capable of delivering in the bowl 6 said low-viscosity composition, supplied at a pre-selected rate by a volumetric pump, which is not shown; in the tubular casing 16 there is a distributor 18 that conveys a flow of additional compressed air on the external wall 8 of the bowl 6, forming an air cone which contains said beam of finely-divided droplets externally, allowing it to be opened or closed, in order to vary the surface covered by the beam and thus to cover strips of different dimensions, while keeping the position of the spraying unit 5 fixed.

The tubular casing 16 is provided with a flange 19, in which the turbine motor 12 is contained, provided with threaded holes 20 and 21 to which there are connected the fittings of the lines of compressed air delivered to the turbine 12 and to the distributor 18; the flange 19 is fastened, by means of bolts 22 to an insulating casing 23 of an electrode 24, which is connected to the positive pole of a source of electrical energy, which is not shown, and is operationally connected to the nozzle 17 by means of a pin, which is not shown, screwed into the hole 25; the printing plate 1 is charged negatively, since it is connected to ground.

There is indicated with 26 an optical detector capable of reading the rate of rotation of the turbine motor 12, operatively connected to a control unit, indicated by the block 27; the control unit 27 controls the delivery of compressed air through the jets 13, to maintain the rate of rotation of the turbine motor 12 and of the spraying cone 6, at a constant pre-selected value suitable for breaking up into finely-divided droplets said composition delivered by the nozzle 17.

As shown in Fig. 1, the spraying unit 5 is placed at a pre-selected distance from the printing plate 1, preferably at about 450 mm, and is inclined at a pre-selected angle, preferably of about 30°, with respect to a line orthogonal to said printing plate 1. Due to evaporation of a large part of the solvent, the finely-divided droplets are very viscous, when they come into contact with the light-sensitive layer of said plate 1 and drying is quickly completed, due to the heat absorbed from the plate 1.

When the viscosity of the droplets which reach the light-sensitive layer is too low, they eatch the light-sensitive layer and also cause sticking of the protection paper. When the viscosity is too high, a dust is formed rather than protrusions.

A preferred range of viscosity of the droplets when they reach the light-sensitive layer is of from 3000 to 6000 centipoises.

An example of low-viscosity (about 5 centipoises) matting composition, according to this invention is as follows

| | |
|---|---|
| Water | 100 parts in weight |
| Ethanol | 8 |
| Tecol V 24 (polyacrylic acid) | 10 |
| Ammonia | 6 |
| Pluronic (BASF; surface-active, copolymer of ethylene and propylene oxide) | 0.05 |

The atomization bowl 6, receives from the nozzle 17 a pre-selected delivery of said low-viscosity matting composition, and, by rotation, atomizes it through the holes 7, forming a beam of finely-divided droplets, charged positively by the electrode 24. The beam of droplets, contained externally by the air cone formed by the wall 8 of the atomization bowl 6, is attracted by the printing plate 1, charged negatively, and is deposited on it in the amount of 40-60x10³ droplets per square centimeter; said droplets are very viscous (about 4000 centipoises) due to the evaporation of a large part of the solvent, when they come into contact with the light-sensitive layer of said plate 1.

As already said the delivery of said low-viscosity matting composition through the nozzle 17 is adjusted by said volumetric pump, while the atomization of the composition is adjusted through the speed of rotation of the atomization bowl 6, by varying the pressure of the air driving the turbine motor 12; at a low pressure, of 0.5 atm, comparatively larger and more viscous droplets are obtained, while with a high pressure, of 3.5 atm, very fine and less viscous droplets are obtained; the rotation speed of the atomization bowl 6 is preferably of 30,000 rpm, in order to obtain droplets having an average size of 2-4 micron and a viscosity of about 4000 centipoise, when they come into contact with the light-sensitive layer of the plate 1.

During the operations, the detector 26 and the control unit 27 control any variations in the speed of the atomization bowl 6 with respect to the pre-set value, due to possible deposits that accumulate in the atomization bowl 6.

The attraction of the droplets toward the printing plate 1 varies with the electrostatic tension provided by the electrode 24; while a low tension, such as for example of 30 KV, is hardly effective, a high tension, such as for example of 80 KV, also thrusts toward the plate 1 droplets which are too large, thus causing its pricking, that is, the etching of the light-sensitive layer; the electrostatic tension of the electrode 24 is preferably of 50 KV.

The inclination of the unit 5 with respect to the plate 1 is selected in such a way that the force of gravity predominates over the electrostatic attraction in the case of the droplets which are too large and makes them fall to the ground while the smaller droplets are electrostatically attracted on the layer 1.

With the method and equipment described there is thus accomplished an efficient matting of the light-sensitive layer of the printing plate 1.

## Claims

1. Method for applying a matting layer over the light-sensitive layer of a printing plate (1) comprising a support and a light-sensitive layer, characterized in that (i) over said light-sensitive layer there is sprayed a beam of finely-divided droplets of a low-viscosity composition comprising at least a solvent and at least a compound suitable for matting and easily soluble in a development bath, (ii) the spraying step is performed under such conditions that a large part of said solvent evaporates before said droplets reach said light-sensitive layer, so that said droplets are very viscous when they reach said light-sensitive layer, adhere to it, and dry quickly, thus forming minuscule protrusions.

2. Method according to claim 1, characterised in that said printing plate (1) is made to slide while performing said spraying step.

3. Method according to claim 1, characterised in that a pre-set electrical charge is supplied to said beam of finely-divided droplets.

4. Method according to claim 1, characterized in that
- said beam of finely-divided droplets is formed by means of an atomization bowl (6) feeded at a pre-selected rate with said low-viscosity composition;
- said atomization bowl rotates at a pre-selected rate and at a pre-selected distance from said printing plate, being inclined at a pre-selected angle to said printing plate (1), so that a large part of said solvent evaporates before said droplets reach said light-sensitive layer, so that said droplets are highly viscous when they reach said light-sensitive layer, adhere to it, and dry quickly, forming minuscule protrusions.

5. Method according to claim 4, characterized in that around said beam of finely-divided droplets an air cone is formed capable of containing said beam externally.

6. Method according to claim 1, characterized in that said printing plate (1) is kept at a temperature of from 40°C to 60°C.

7. Method according to claim 4, characterized in that said atomization bowl (6) is placed at a distance of about 450 mm and is inclined at an angle of about 30° with respect to a line orthogonal to said printing plate (1).

8. Method according to claim 4, characterized in that said atomization bowl (6) is driven in rotation by motor means (12), operationally connected in the control means (27) capable of keeping the rate of rotation of the same atomization bowl (6) at a pre-selected value, on the basis of signals from detector means (26) of the rate of rotation of said atomization bowl (6).

9. Method according to claim 1, characterized in that said low-viscosity composition has a viscosity ranging from 2 to 10 centipoise, and that said very viscous droplets have a viscosity ranging from 3000 to 6000 centipoise.

10. Method according to claim 1, characterized in that said low-viscosity composition, having a viscosity equal to 5 centipoise, is constituted by about 10% (w/w) of acrylic acid and by about 90% (w/w) of an aqueous water/ethanol/ammonia solution.

11. Apparatus for applying a matting layer over the light-sensitive layer of a printing plate (1) comprising a support and a light-sensitive layer, characterized in that it comprises
- spraying means (5) capable of directing on said light-sensitive layer a beam of finely-divided droplets of a low-viscosity composition comprising at least a solvent and at least a compound suitable for matting and easily soluble in a development bath,
- said spraying means (5) being operated under such conditions that a large part of said solvent evaporates before said droplets reach said light-sensitive layer, so that said droplets are very viscous when they reach said light-sensitive layer, adhere to it, and dry quickly, forming minuscule protrusions.

12. Apparatus according to claim 11, characterized in that it comprises guide means (2) for making said printing plate (1) to slide while said spraying step is performed.

13. Apparatus according to claim 11, characterized in that it comprises means (24) capable of delivering a pre-selected electrical charge to said beam of finely-divided droplets.

14. Apparatus according to claim 11, characterized in that the spraying means (5) comprise in turn
- an atomization bowl (6) feeded at a pre-selected rate with said low-viscosity composition, and
- said atomization bowl (6) rotates at a pre-selected rate and at a pre-selected distance from said printing plate (1), being inclined at a pre-selected angle to said printing plate (1).

15. Apparatus according to claim 14, characterized in that it comprises means (18) suitable to form around said beam of finely-divided droplets an air cone capable of containing said beam externally.

16. Apparatus according to claim 11, characterized in that said printing plate has a temperature of from 40°C to 60°C.

17. Apparatus according to claim 14, characterized in that said atomization bowl (6) is placed at a distance of about 450 mm and is inclined at an angle of about 30° with respect to a line orthogonal to said printing plate (1).

18. Apparatus according to claim 14, characterized in that said atomization bowl (6) is driven in rotation by motor means (12), operationally connected with control means (27) capable of keeping the rate of rotation of the same atomization bowl (6) at a pre-selected value, on the basis of signals from detector means (26) of the rate of rotation of said atomization bowl (6).

19. Apparatus according to claim 11, characterized in that said low-viscosity composition has a viscosity ranging from 2 to 10 centipoise, and that said very viscous droplets have a viscosity ranging from 3000 to 6000 centipoise.

20. Apparatus according to claim 11, characterized in that said low-viscosity composition, with a viscosity equal to 5 centipoise, is constituted by about 10% (w/w) of acrylic acid and by about 90% (w/w) of an aqueous water/ethanol/ammonia solution.
